# EUROPEAN PATENT SPECIFICATION

(11) **EP 1 722 274 B1**
(45) Date of publication and mention of the grant of the patent: **08.09.2010**
(21) Application number: 05103878.4
(22) Date of filing: 10.05.2005
(51) Int. Cl.: G03F 7/32

(54) **Alkaline developer for radiation sensitive compositions**
Alkalischer Entwickler für strahlungsempfindliche Zusammensetzungen
Révélateur alcalin pour compositions sensibles aux rayonnements

(43) Date of publication of application: 15.11.2006
(73) Proprietor: Agfa Graphics N.V., 2640 Mortsel (BE)
(72) Inventor: Gries, Willi - Kurt,, 2640 Mortsel (BE); Van Damme, Marc,, 2640 Mortsel (BE); Boxhorn, Mario,, 2640 Mortsel (BE); Meeus, Pascla,, 2640 Mortsel (BE)
(74) Representative: Goedeweeck, Rudi

(56) References cited:
- EP-A- 0 639 797
- EP-A- 1 006 410
- EP-A- 1 172 699
- US-A1- 2003 215 755

## Description

### FIELD OF THE INVENTION

The present invention relates to an alkaline developer for irradiated radiation sensitive compositions, which developer is based on water and contains at least one inorganic salt having an alkaline reaction. The present invention also relates to an alkaline developer for irradiated lithographic printing plate precursors and a method to develop a lithographic printing plate precursor therewith.

### BACKGROUND OF THE INVENTION

It is well known in the prior art to add surfactants to alkaline developing compositions. For example it is known from EP 099 003 and EP 134 407 to use an anionic surfactant in a developer that has a pH of from 8 to 12, wherein the surfactant is added to stabilize the solution at low temperature.

According to EP 366 321 a surfactant is added to prevent overdevelopment of positive working compositions, which surfactant may be non-ionic such as polyoxyethylene lauryl ether or an ethylene oxide/propylene oxide condensate of poly(ethylene) glycol; the latter being prefered since it also prevents soiling deposits being formed on the plate surface when developing radiation sensitive plates in some automatic plate processors using hard water in their plate washing section. The pH of the developer is not given explicitely.

From EP 720 060 it is known to use one or more surfactant to adjust the surface tension and thereby allow a fast wetting of the sensitive layer, in particular when spraying the developer on the plate. Cationic, anionic, betainic and non-ionic surfactants, alone or in combination, are disclosed to be suitable therefore without further specification. EP 720 060 is related to alkaline developers, but the pH is not explicitely disclosed.

Aqueous alkaline developing solutions are known from EP 732 628, that comprise a non-ionic surfactant and at least another surfactant selected from anionic or amphoteric surfactants. Said developing solutions allow a reduced amount of sludge and less foam.

According to EP 992 854 an amphoteric and at least one anionic surfactant are used together with an N-alkoxylated amine in an alkaline aqueous developer concentrate. Said developer concentrate makes a developer possible having a high development capacity and a reduced tendency of forming unwanted depositions on the developed plates and in the processing apparatus. The amphoteric surfactant disclosed in EP 992 854 preferably is an aminoacid, a salt thereof or an alkylamidoalkylbetain and the anionic surfactants preferably are C₂- to C₁₆-alkyl or aryl sulfates. In addition, the concentrate of EP 992 854 can further contain ingredients like non-inonic and cationic surfactants. The addition of N-alkoxylated amines has the tendency to increase the turbidity of the resulting developers. Thus these developers can give increased settlement, which reduces the circulation in the processor. The consequence is a continuous reduction of circulation flow during usage, which finally can end up in a blockage of processors's spray bars. On the other hand most of the settlements remain in the processor and need to be removed at the end using special cleaning agents.

Non-ionic surfactants in general and several classes thereof are disclosed in EP 1 260 867 for developers suitable to develop thermal printing plates. For the developers containing a surfactant taken from such a class are described therein good image forming properties and a high printing durability.

A class of non-ionic surfactants known to be suitable for alkaline developers are mixed polyethyleneoxy/polypropyleneoxy-blockcopolymers, which are disclosed e.g. in EP 555 098 for a developer that is capable to develop a fine resist pattern; and in US 4,945,030 to enable a developer with a high initial alkali content with little damage to the image.

The use of non-ionic surfactants having a linear polar polyoxyalkylene moiety and a hydrophobic residue, hereinafter also called "linear non-ionic surfactants" is rather common and is known, for example from EP 1 457 837, wherein the hydrophobic residue may be an unsubstituted or mono-substituted phenyl, naphthyl or higher annealed aromatic carbocycle and wherein the developing solution comprising such a surfactant in addition comprises a branched surfactant and is used for the development of a positive working heat-sensitive plate. Such linear non-ionic surfactants are also disclosed in EP 1 199 606 as ingredients for a developing solution that is useful for a specific photosensitive composition; in US 6,562,555, wherein the linear non-ionic surfactant is used as a coating attack-supressing agent; in EP 1 353 235 to suppress foaming; in EP 1 334 824, US 6,686,126 and US 6,638,687 to achieve e.g. high printing durability and printing quality; in EP 1 253 472 for IR-plate developers that give a sharp and clear image without damage to the image; and in US 6,641,980 and EP 1 288 722, wherein such coumpounds falling under a broadly defined hydrophobicity range are disclosed to enhance printing durability and running performance of the developer.

A linear non-ionic surfactant, having a tri-substituted hydrophobic phenyl substituent, is disclosed in US 6,248,506 to be unfavourable, as it gives large amounts of sinking residues when used in the developers for UV curable photoresists. The disclosed developers are used for the manufacture of printed circuit boards and are free of silicate. Only when combining such surfactants with an anionic surfactant leads to a useful developer.

EP-A-0 639 797 discloses a developer which may comprise a variety of non-ionic surfactants, including polyoxyethylene polyoxypropylene surfactants.

US 2003/215755 discloses a developer comprising an aromatic alkoxylate in combination with a polyol.

Although, as set forth above, there have been made many efforts to reduce deposits in the developing apparatus when processing printing plates and to increase the developing solution stability, the known developing solutions for printing plates are still unsatisfactory in this respect, so that there still is a demanding need to find new developer compositions, that further reduce depositions in the developing apparatus and on the processed printing plates, especially during long run processing, and that increase the sedimentation stability of used developers.

The depositions when using a developer according to the prior art are formed from already detached components of the layer, that arc unsufficiently dissolved or dispergated and are deposited on the recording material again or are carried into downstream stations (washbath, gumming station) of the developing machine. Already developed recording materials may become useless in this way. It is mainly during development in machines that components of the layer which are contained in the developer in the form of cakes, filaments or pigment residues, are deposited on the printing plates. In addition, such depositions are formed in the developing machine reducing the circulation flow and decreasing the efficiency of processing, whereby the cleaning effort at the end is high and often aggressive cleaning agents have to be used.

### OBJECTS OF THE INVENTION

It is therefore an object of the present invention to provide an alkaline developer for irradiated radiation sensitive compositions, that leads to less depositions in the developing apparatus and on the processed printing plates, especially during long run processing. A further advantage of the developer of the present invention is, that such developers, when used, have an increased sedimentation stability.

Therefore it is a further target of the present invention to fmd a developer, which results in a stable process with constant circulation flow in the processor and a low cleaning effort at the end of the process, giving reduced settlements, which easily can be removed with plain water.

Further aspects and advantages of the invention will become apparent from the description hereinafter.

### SUMMARY OF THE INVENTION

The present invention provides an alkaline developer for irradiated radiation sensitive compositions as defined in claim 1, which developer is based on water and comprises at least one inorganic salt having an alkaline reaction, wherein the developer has a pH of at least 11 and comprises a surfactant of a specific formula, that surprisingly leads to less depositions and a superior stability of the developer, if said developer comprises an alkaline reacting silicate.

### DETAILED DESCRIPTION OF THE INVENTION

The present invention relates to an alkaline developer for irradiated radiation sensitive compositions, which developer is based on water and comprises at least one alkaline reacting silicate, characterized in that the developer has a pH of at least 11 and comprises at least a surfactant of formula (Ia): 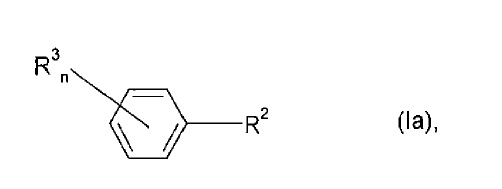 wherein
- R²: represents a hydrophilic group comprising a polyethyleneoxy group with at least 6 ethyleneoxy units, and
wherein the concentration of the silicate is at least 0.2 weight-% and that of the surfactant of formula (Ia) at least 0.05 weight-%, in each case based on the total weight of the developer. Alkaline developer solutions having a pH range from 11.5 to 14, in particular from 12.0 to 13.5, are preferred.
- R³: represents a 1,1-phenylethyl or a t-butyl group, in particular a 1,1-phenylethyl group, and
- n: means 2 or 3, in particular 3.

Besides the polyethyleneoxy group, R² may comprise any organic group, that is stable in water, as long as the solubility criterium for R²-H is as defined above. In particular, R² may comprise polypropyleneoxy blocks and further polyethyleneoxy blocks. In a preferred embodiment of the present invention, R² only consists of a polyethyleneoxy chain and the surfactant is of formula (Ib): 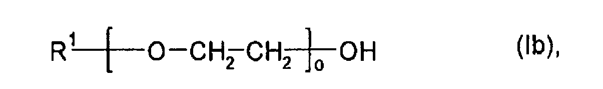 wherein
- R¹: is defined as set forth above, and
- o: is an integer and is at least 6, preferably from 8 to 50 and particularly preferred from 10 to 30.
Particular preferred surfactants of formula (Ia) are given by the following examples:

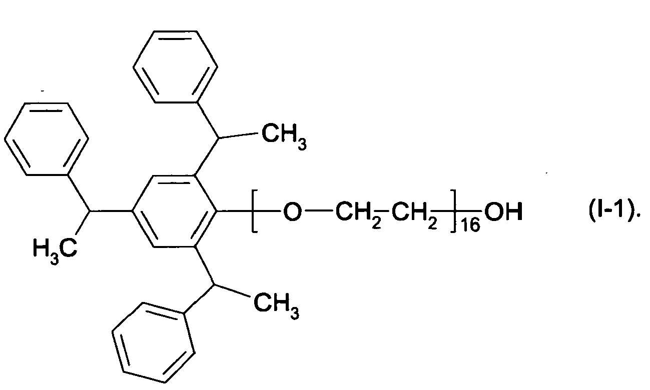

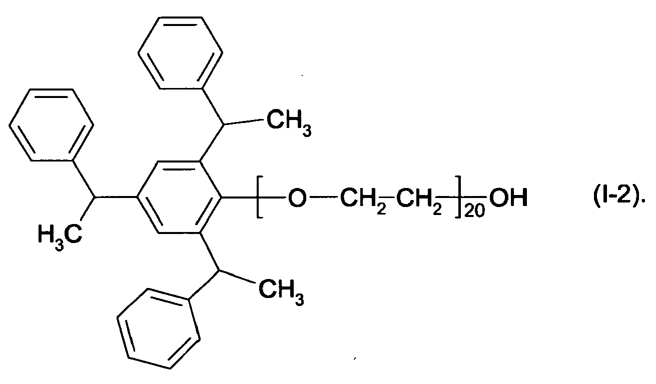

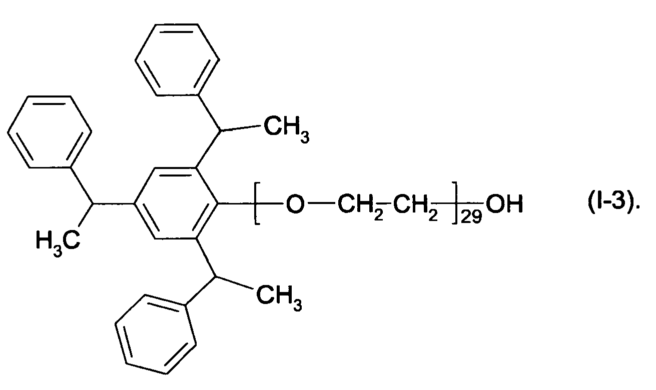

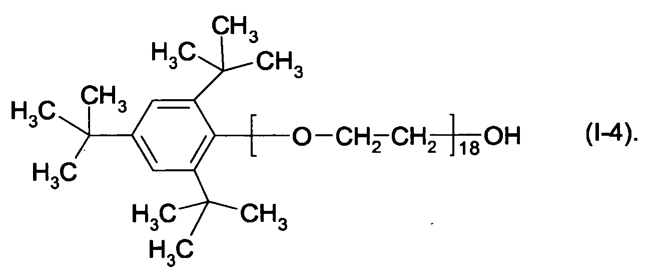

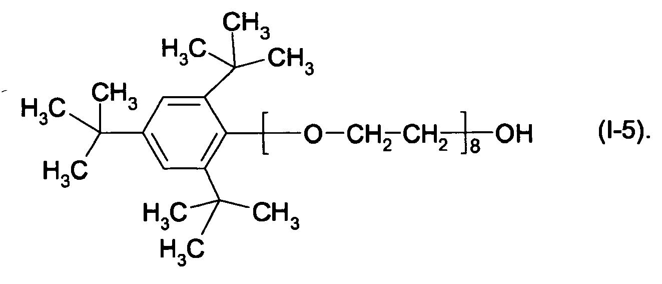

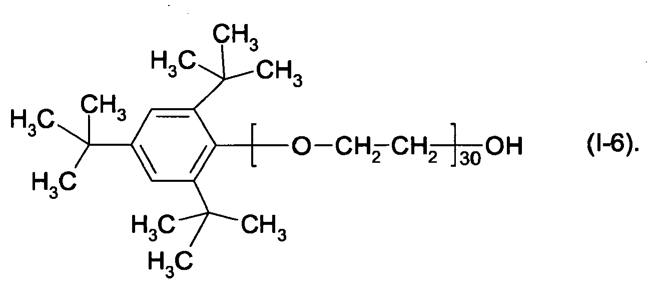

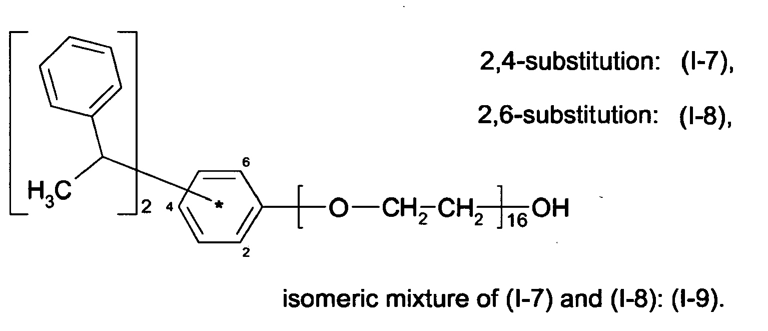

The above mentioned alkaline reacting silicate shows alkaline properties when dissolved in water. For example, silicates of alkali metals such as sodium silicate, potassium silicate and lithium silicate, and ammonium silicate can be used. Such alkaline reacting silicates may be used alone or in combination.

The developing performance of the alkaline aqueous solution comprising the above mentioned alkaline reacting silicate can be easily controlled by adjusting the mixing ratio of the components constituting the silicate, that is, silicon dioxide (SiO₂) and alkali oxide represented by M₂O, wherein M is an alkali metal or ammonium group, and the concentration of the alkali silicate.

In the above mentioned alkaline aqueous solution, it is preferable that the molar ratio of the alkali oxide (M₂O) to the silicon dioxide (SiO₂) be in the range of 1:0.5 to 1:7.0, from the aspect of moderate alkalinity and developing performance, and more preferably 1:1.0 to 1:5.0.

The concentration of the alkaline reacting silicate in the developing solution is preferably in the range of 0.5 to 10 weight-% from the aspect of developing performance, processing ability and waste fluid treatment, more preferably 1.0 to 8 weight-%, and most preferably 2 to 6 weight-%, with respect to the total weight of the developing solution.

In addition to the metal silicate the developer of the present invention preferably comprises at least one extra inorganic or organic salt having an alkaline reaction in water, that preferably is selected from the group consisting of an alkali metal hydroxide, an alkaline earth metal hydroxide or an ammonium hydroxide, in particular LiOH, KOH or NaOH, or an alkali metal, alkaline earth metal or ammonium salt of an inorganic or organic acid, in particular sodium dihydrogen phosphate or potassium dihydrogen phosphate, disodium hydrogen phosphate or dipotassium hydrogen phosphate, sodium borate, disodium or dipotassium carbonate, sodium or potassium hydrogencarbonate (bicarbonate), sodium or potassium gluconate, an alkali metal salt of an aliphatic, aromatic or araliphatic carboxylic acid, in particular an alkali metal salt of a (C₂-C₁₈)alkanoic acid or of a (C₃₋C₁₈)alkoxyalkanoic acid.

The amount of the extra inorganic or organic salt or salts having an alkaline reaction in water can range from 0 to 15% by weight, preferably from 0 to 8% by weight and most preferred from 0.1 to 6% by weight, based in each case on the total weight of the developer.

The developer not only comprises one surfactant of formula (Ia), but a combination of at least two different surfactants, that can lead to a synergistic effect.

A surfactant according to the present invention is a substance, which reduces the surface tension, mainly in aqueous systems, and has a characteristic structure containing at least one hydrophilic and one hydrophobic functional group. According to nature and charge of the hydrophilic group surfactants are divided into anionic, nonionic, cationic and amphoteric materials (see Surfactants by K. Koswig in Ullmann's Encyclopedia of Industrial Chemistry, Wiley-VCH 2002, Online Posting Date: June 15,2000).

Most important anionic surfactants are carboxylates, sulfonates, sulfates, phosphates and phosphonates having a hydrophobic part based on alkyl, alkylaryl, fluoralkyl, silaalkyl, thiaalkyl and oxaalkyl groups.

Usually nonionic surfactants are ethoxylates, which are formally condensation products of hydrophobic alcohols, phenols, mercaptanes, amines, carboxylic acids, carbonamides and others with oligoglycol ethers. Fatty acid esters of glycerol, diglycerol, sugars, hydrogenated sugars such as sorbitol and alkyl(poly)glucosides are also assigned to this class as well as surfactants with semipolar bonded oxygen as hydrophilic group like fatty amine oxides, sulfoxides and phosphine oxides.

Cationic surfactants basically have their cationic structure already present in the molecule as in the case of quaternary ammonium, phosphonium or sulfonium salts. Among them the quaternary nitrogen compound like tetraalkylammonium salts, N,N-dialkylimidazolinium compounds and N-alkylpyridinium salts are the most important.

Amphoteric surfactants are classified as ampholytes, which are compounds having at least on active proton as in the case of aminocarboxylic acids and betaines, which have no mobile protons and are true amphoteric ions containing both cationic and anionic groups.

In addition to this speciality surfactants with heteroatoms in the hydrophobic group can be used. These materials are usually based on fluorocarbons or silicones having hydrophilic groups with anionic, cationic, amphoteric and polyethyleneoxide units.

The developer comprises an extra surfactant of formula (IIa): 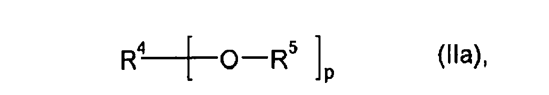 wherein
- R⁴: represents H, a substituted or unsubstituted alkyl group having at least 1 carbon atom, or a monosubstituted or unsubstituted aryl group having at least 6 carbon atoms,
- R⁵: mutually independently represent a polyoxyalkylene group, and
- p: represents an integer of at least 1.

Surfactants of formula (IIa) are hereinafter also summarized as surfactants of general formula (II).

The polyoxyalkylene groups R⁵ may consist of only one type of oxyalkylene, and in this case preferably are polyoxyethylene groups: -(-CH₂-CH₂-O-)ₓ-H, but in a preferred embodiment of the present invention, the polyoxyethylene group consists of a mixture of at least two different oxyalkylene units, that can be randomly arranged, but preferably are arranged in blocks like -Z¹-Z²-H, -Z²-Z¹-H, -Z¹-Z²-Z¹-H, -Z²-Z¹-Z²⁻H etc, wherein Z¹ and Z² represent structurally different polyoxyalkylene groups, and preferably
- Z¹: represents polyoxyethylene groups -(-CH₂-CH₂-O-)ₓ-,
- Z²: represents polyoxypropylene groups -(-CH₂-CH(CH3)-O-)_{y}-, and
- x, y: mutually independently are integers from 3 to 200.

Further particularly preferred extra surfactants are of formulae (IIb), (IIc) or (IId), that hereinafter also are summarized as surfactants of general formula (II):

HO―R⁶ (IIb),

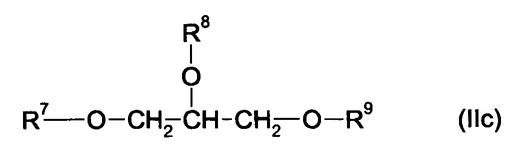

or 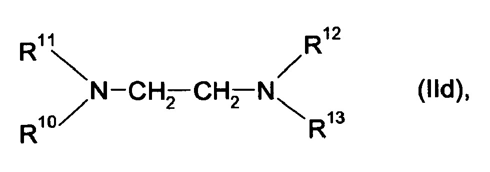 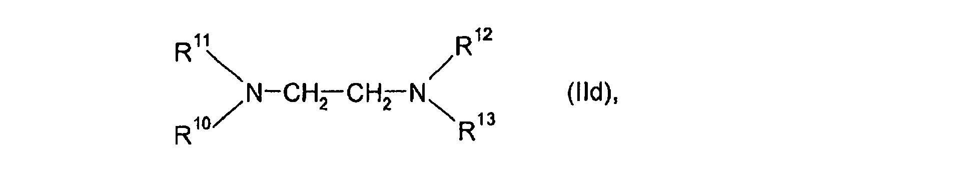 wherein R⁶ to R¹³ mutually independently consist of polyoxyethylene and polyoxypropylene groups, and preferably of Z¹ and Z² blocks being aranged as -Z¹-Z²-H, -Z²-Z¹-H, -Z¹-Z²-Z¹-H or -Z²-Z¹-Z²-H

In all cases the polyoxyethylene block (hereinafter also called ethyleneoxide block or EO block) represents the hydrophilic moiety and the polyoxypropylene block (hereinafter also called propyleneoxide block or PO block) represents the hydrophobic moiety. In the context of the present invention it has been found, that the aforementioned synergistic effect is particularly pronounced, when combining surfactants of formula (Ia) with surfactants of formulae (IIb), (IIc) or (IId), wherein the surfactants of formulae (IIb), (IIc) or (IId) have a total molecular weight of the PO block(s) of at least 2000 g/mol, in particular from 2200 to 6000 g/mol and comprise 25 to 55 weight-% ethyleneoxide based on the total molecular weight of the PO blocks and the EO blocks in the molecule, in particular 30 to 50 weight-% ethyleneoxide.

The surfactant of formula (Ia) can be combined with an extra surfactant in any ratio, preferably in a ratio by weight from 100 : 1 to 1 :100, but particulary when combining it with a surfactant of formula (II), the surfactant of formula (Ia) is advantageously used in a lower amount than the surfactant of formula (II). Preferred ratios by weight of the surfactant of formula (Ia) to the surfactant of formula (II) are 1 : 1 to 1 : 80, in particular from 1 : 2 to 1 : 50, and most preferred from 1 : 4 to 1 : 20.

It is particularly preferred, that the developer of the present invention contains non-ionic surfactants in an amount of at least 50% by weight based on the total amount of surfactants in the developer, preferably at least 80% by weight and particular preferred at least 90% by weight. Most preferred the developer of the present invention contains solely surfactants of the non-ionic type.

The overall amount of all surfactants used in the developer preferably ranges from 0.15 to 18.0 wt.-%, 0.30 to 9.0 wt.% being particularly preferred, wherein the wt.% are based in each case on the total weight of the developer.

The developer of the present invention usually has an electric conductivity of 10 to 50 mS/cm, 20 to 40 mS/cm being preferred.

Examples of preferred compounds of formula (II) are listed in the table below.

| | **Trade Name** | **Mol. Weight of the PO block(s) (g/mol)** | **Weight-% EO** |
|---|---|---|---|
| (II-1) | Pluronic PE 9400^{®} | 2750 | 40 |
| (II-2) | Pluronic PE 10500^{®} | 3250 | 50 |
| (II-3) | Pluronic PE 10400^{®} | 3250 | 40 |
| (II-4) | Pluronic PE 10300^{®} | 3250 | 30 |
| (II-5) | Symperonic T/904^{®} | 4000 | 40 |

The developer according to the present invention preferably contains further components, that are selected as known in the art depending on the type of the recording materials to be developed. Particular preferred components used for the developer of the present invention are chelating agents and/or dispersants/emulsifiers and/or other additives like solubilizers e. g. aliphatic or aromatic alcohols, antifoaming agents, coloring dyes, oxidation stabilizers and others.

The chelating agents used for the developer of the present invention are selected from low molecular and/or polymeric compounds. According to the definition of W. L. Howard and D. Wilson, Kirk-Othmer Encyclopedia of Chemical Technology 2003 (online posting date July 18, 2003, a chelating agent, or chelant, contains two or more electron donor atoms that can form coordinate bonds to a single metal atom. Preferred chelating agents are selected from phosphorus containing compounds like phosphates, phosphonates or aminophosphonates, hydroxycarboxylates, aminocarboxylates, diketones, polyamines, aminoalcohols, oximes, Schiff bases, sulfur containing compounds, aromatic compounds like phenols, aminophenols, aromatic heterocyclic compounds like pyridines, pyrrols or phenanthrolines, ether compounds like macrocylic crown ethers or cryptates. Basicly the electron donating functionalities are incorporated in organic molecules. The molecular weight of these compounds can range from typical values for single organic compounds to materials of oligomeric or polymeric structure. Examples of such materials are e. g. alkali or ammonium salts of di- or triphosphoric acid, of metaphosphoric acid, of hydroxyethylene diphosphonic acid, of amino tri(methylenephosphonic acid), of ethylenediaminetetra(methylenephosphonic acid), of diethylenetriaminepenta(methylenephosphonic acid), of tartaric acid, of citric acid, of gluconic acid, of 5-sulfosalicyclic acid, of dicarboxyinulin, of ethylenediaminetetraacetic acid, of hydroxyethylethylenediaminetriacetic acid, of nitrilotriacetic acid, of n-dihydroxyethylglycine, of ethylenebis(hydroxyphenylglycine), of methylglycintriacetic acid, of N-(1,2-dicarboxyethyl)aspartic acid, of poly(aspartic acid) derivatives, of poly(p-vinylbenzyliminodiacetic acid), acetylacetone, trifluoroacetylacetone, thenoyltrifluoracetone, ethylenediamine, diethylenetriamine, triethylenetetramine, triaminotriethylamine, polyethyleneimines, triethanolamine, diethanolamine, monoethanolamine, N-alkylated ethanolamines, 2-amino-1-butanol, 2-amino-2-methyl-1,3-propanediol, 2-amino-2-methyl-1-propanol, 2-amino-2-ethyl-1,3-propanediol, 2-amino-2-methyl-1-propanol, n-hydroxyethylethylenediamine, tris(hydroxymethyl)aminomethan, dimethylglyoxime, salicylaldoxime, disalicylaldehyde, 1,2-propylenediamine, toluenedithiol, dimercaptopropanol, alkali or ammonium salts of thioglycolic acid, ethyl xanthogenic acid, diethylcarbamic acid, diethyl dithiophosphoric acid, thiurea, dithione, salicylaldehyde, disulfopyrocatechol, chromotropic acid, oxine, 8-hydroxyquinoline, alkali or ammonium salts of oxinesulfonic acid, tetraphenylporphin, phthalocyanine, dipyridyl, o-phenanthroline, dibenzo-[18]-crown-6, 2,2,2-cryptate. In a highly preferred embodiment of the present invention the chelating agent is selected from gluconic acid, an alkali metal, alkaline earth metal or ammonium salt of gluconic acid, or the delta-lactone of gluconic acid. The gluconic acid complexing agents have the further advantage that they are particularly environmentally friendly (they are even used in foods) and readily biodegradable. Furthermore aminoalcohols, like triethanolamine and/or tris(hydroxymethyl)aminomethane are highly preferred. The amount of the chelating agents is in general from 0.05 to 10 % by weight, preferably from 0.1 to 5 % by weight, based in each case on the total weight of the developer.

The developer of the present invention can also contain an N-alkoxylated, mono- or polyvalent amine, but it is highly preferred, that the developer is essentially free from said N-alkoxylated, mono- or or polyvalent amines. By essentially free is meant less than 2 % by weight (wt.-%), in particular less then 1 wt.-%, based on the total weight of the concentrate.

The dispersant preferably used for the developer of the present invention can be selected from a material, which is readily soluble in water having anchoring groups for the interaction with other compounds. The term dispersant is used according to the definition of R. Heusch and K. Reizlein, Ullmann's Encyclopedia of Industrial Chemistry 2002. (online posting dated June 15, 2000). According to this publication dispersants are products or mixtures of products that can promote the formation of a dispersion or stabilize a dispersion. The term dispersion is applied to a system of several phases in which one is continuous and at least one other is finely distributed therein. Dispersants are usually of oligomeric or polymeric structure. The dispersant preferably is selected from polyphosphates, ligninsulfonic acids, formaldehyde condensation products, the latter in particular with aromatic compounds, and protein condensation products. Preferred dispersants are water soluble polymers like poly(ethyleneoxide) polymers or ethyleneoxide copolymers, poly(vinylether) or vinylether copolymers, poly(ethyleneimines) or ethyleneimine copolymers, poly(acrylic(methacrylic)acid) or acrylic(methacrylic) acid copolymers, poly(maleic acid) or maleic acid copolymers, poly(amino acids) or amino acid copolymers, polysaccharides or modified polysaccharides, poly(acrylamide) or acrylamide copolymers, poly(vinylalcohols) or vinylalcohol copolymers, poly(vinylpyrrolidone) or vinylpyrrolidone copolymers. Also suitable are polymers or copolymers with attached groups, which easily can be ionized. Examples of such groups are carboxylic, sulfate, sulfonate or phosphonate anions or amino, amido or heterocyclic amino cations. Anions and cations can be existing in one polymer (polybetaines). In case of copolymers the distribution of the different units can be random or blockwise.
An emulsion is also a disperse system consisting of two (or more) mutually insoluble or sparingly soluble liquids (see R. Heusch, Emulsions in Ullmann's Encyclopedia of Industrial Chemistry 2002, online posting date: June 15, 2000). According to this agents used for the preparation of emulsions are termed emulsifiers. Emulsifiers are usually selected from the group of surfactants, preferably from those of the present invention, from the polymers as disclosed for the dispersant of the present invention, and from solid particles. Examples of such solid particles include various types of clays, activated carbon or solidified fats.

The amount of dispersant and/or emulsifier is in general from 0 to 10 % by weight, preferably from 0 to 5 % by weight, based in each case on the total weight of the developer.

Other additives e. g. solubilizers, antifoaming agents, coloring dyes, oxidation stabilizers and others can also be present. The concentration ranges according to the desirable effect between 0 and 10 % by weight, preferably from 0.01 to 5 % by weight, based in each case on the total weight of developer.

The developer of the present invention can not only be prepared as a ready-to-use solution, but also e. g. as a replenisher and the present invention is related to all known packaging.

The developer of the present invention is preferably prepared in a ready-to-use concentration, but it also can be prepared as a concentrate, which has to be diluted with water.

The replenisher for the developer of the present invention differs from the developer in that the ready to use concentration therein of the at least one inorganic salt having an alkaline reaction in water is from 1.05 to 5.0 fold, preferably from 1.1 to 3.0 fold, higher and also the concentrations of the other components differ from those of the developer by a factor from 1.0 to 5.0, preferably from 1.0 to 2.0 or that there is additionally at least one inorganic salt having an alkaline reaction in water. Extra inorganic salts having an alkaline reaction in water, are preferably selected from the group consisting of an alkali metal hydroxide, an alkaline earth metal hydroxide or an ammonium hydroxide, in particular LiOH, KOH or NaOH, or an alkali metal, alkaline earth metal or ammonium salt of an inorganic or organic acid, in particular sodium dihydrogen phosphate or potassium dihydrogen phosphate, disodium hydrogen phosphate or dipotassium hydrogen phosphate, sodium borate, disodium or dipotassium carbonate, sodium or potassium hydrogencarbonate (bicarbonate). The amount of the extra inorganic salt or salts having an alkaline reaction in water can range from 0 to 15% by weight, preferably from 0 to 8% by weight and most preferred from 0.1 to 6% by weight, based in each case on the total weight of the replenisher. The replenisher is preferably prepared in a ready to use concentration, but can also be diluted with water from a replenisher concentrate. The replenisher is added to a partly spent developer in order to restore its full activity.

The developer according to the invention is suitable for most of the negative-working recording materials on the market, in particular for those whose reproduction layer is also provided with one or more water-soluble or water-dispersible top coats. A sizeable advantage of the developer according to the invention is its particularly high developing capacity. The consumption of developer per square meter of recording material thus decreases substantially, so that the developer has to be replenished less frequently. The number of developer changes can be reduced, depending on the addition of replenisher. The stoppage of production is thus avoided and the work involved is also reduced. Furthermore, the developing apparatuses can be cleaned by simply washing out with water. Special cleaning agents are no longer required, what saves costs and prevents environmental pollution, as the cleaning agents used to date for this purpose are as a rule dangerous, environmentally harmful and expensive. As deposits onto the developed plates are not observed when using the developer of the present invention, it is therefore also no longer necessary to provide special filters or other apparatuses for separating off solid components in the developing machines.

The developers according to the invention can be used in all known developing apparatuses, for example in emulsion bath machines, flat table machines having rotating or oscillating brushes or (high-pressure) spray developing machines. On the other hand, it was frequently required to date to use special developing apparatuses in which the brushes are encapsulated or completely surrounded by developer in order to avoid undesired foam formation. In addition, it was often necessary to lay the feed lines for the developer under the liquid level, to keep the developer in a special forced circulation or to provide the developing zone with a special cover.

With the developer according to the invention, it is possible to develop a multiplicity of imagewise exposed reproduction layers. These layers can contain, as radiation-sensitive components, diazonium salt polycondensates or combinations of polymerizable, ethylenically unsaturated monomers and photopolymerization initiators. In addition, polymeric binders, plasticizers, sensitizer dyes, other dyes or pigments, control substances, irradiation indicators, surfactants and/or wetting agents may be added.

Particularly suitable binders in radiation-sensitive layers are polymers which are insoluble in water but soluble or at least swellable in organic solvents and in aqueous alkaline solutions. Polymers having pendant carboxyl groups are particularly suitable, for example copolymers having units of (meth)acrylic acid, crotonic acid or maleic monoesters or polymers having hydroxyl groups, some or all of which have been reacted with cyclic dicarboxylic anhydrides. The polymeric binders generally have a molecular weight M_{w} of from 500 to 1,000,000, in particular from 1000 to 200,000, and an acid number of from 10 to 250, preferably from 20 to 200. Preferred binders are copolymers (mixed polymers) of (meth)acrylic acid, of crotonic acid or of vinylacetic acid. The comonomers are in particular alkyl(meth)acrylates, hydroxyalkyl (meth)acrylates, allyl (meth)acrylates, aryl (meth)acrylates and/or (meth)acrylonitrile. Copolymers of maleic anhydride and unsubstituted or substituted styrenes, unsaturated hydrocarbons, unsaturated ethers or esters may also be mentioned. The anhydride groups contained therein may also be esterified. The amount of the binders in the radiation-sensitive mixture is in general from 10 to 90% by weight, preferably from 15 to 60 % by weight.

The monomers in the photopolymerizable mixtures are in general ethylenically unsaturated compounds, in particular acrylic or methacrylic esters of dihydric or polyhydric alcohols. Ethylene glycol di(meth)acrylate, diethylene glycol di(meth)acrylate, (meth)acrylates of trimethylolethane, trimethylolpropane, pentaerythritol, dipentaerythritol and of polyhydric alicyclic alcohols may be mentioned specifically. The reaction products of mono- or diisocyanates with partial esters of polyhydric alcohols can also advantageously be used. Finally, polymerizable compounds which additionally contain photooxidizable groups, if required also urethane groups, are also suitable. The photooxidizable groups are in general amino, urea or thio groups which may also be part of heterocyclic rings. Especially suitable photooxidizable groups are triethanolamino, triphenylamino, thiourea, imidazole, oxazole, thiazole, acetylacetonyl, N-phenylglycine and ascorbic acid groups. Among these, the polymerizable compounds having primary or secondary but in particular tertiary amino groups are preferred.

The photoinitiators can be selected from a number of classes of substances. In particular, derivatives of benzophenone, of acetophenone, of benzoin, of benzil, of fluorenone, of thioxanthone, of acridine or of quinazoline and of polynucleic quinones may be mentioned. Trichloromethyl-s-triazines, 2-halomethyl-5-vinyl-[1,3,4]oxadiazole derivatives, halooxazoles substituted by trichloromethyl groups and carbonyl methylene heterocycles containing trihalomethyl groups (EP-A 135 863 = US-A 4 966 828) also deserve mention. Finally, alkylbisacylphosphine oxides, alkylarylbisacylphosphine oxides, titanocenes, hexaarylbisimidazoles, ferrocenes, azidosulfonylphenylphthalimides, ketoxime ethers, and onium compounds (especially diaryliodonium, diazonium or sulfonium compounds) are also suitable.

The radiation-sensitive layer may contain, as sensitizer dyes, in particular photoreducible xanthene, fluorene, benzoxanthene, benzothioxanthene, thiazine, oxazine, coumarin, pyronine, porphyrin, acridine, azo, diazo, cyanine, merocyanine, diarylmethyl, triarylmethyl, anthraquinone, phenylenediamine, benzimidazole, fluorochrome, quinoline, tetrazole, naphthol, benzidine, rhodamine, indigo and/or indanthrene dyes. Also suitable are optical brighteners. The amount of the sensitizer dyes is in general from 0.01 to 15%, preferably from 0.05 to 5% by weight, based in each case on the total weight of the nonvolatile components of the radiation-sensitive layer.

In order to increase the photosensitivity further, the layer may additionally contain coinitiators. For example, the combination of titanocenes and trichloromethyl-s-triazines, of titanocenes and ketoxime ethers and of acridines and trichloromethyl-s-triazines is known. A further increase in sensitivity can be achieved by adding dibenzalacetone or amino acid derivatives. The amount of the initiator or initiators or coinitiator or coinitiators is in general from 0.01 to 20% by weight, preferably from 0.05 to 10% by weight, based in each case on the total weight of the nonvolatile components of the radiation-sensitive layer.

Dyes or pigments may be added for colouring the radiation-sensitive layer. In general, phthalocyanine, rhodamine, triarylmethane, azo, diazo, anthraquinone, naphthol or phenylenediamine dyes or inorganic coloured pigments are used for this purpose.

In order to establish specific properties, inhibitors and control substances may furthermore be present in the layer. These include benzophenone compounds, phosphorus compounds, cycloacetals, quinones, quinolines, naphthoquinones, anthraquinones, ethers, sterically hindered amines, benzothiazols, thiurams, thiocarbamates, phenols, naphthols, benzimidazoles, mercaptobenzimidazoles and phenylenediamines. The amount of the inhibitors and/or control substances is in general from 0.001 to 10% by weight, preferably from 0.005 to 5% by weight, based in each case on the total weight of the nonvolatile components of the radiation-sensitive layer.

Any topcoats present in the recording materials essentially comprise water-soluble or water-emulsifiable polymeric binders. They may also contain wetting agents, adhesion promoters, antifoams, dyes and other assistants. Such topcoats are likewise known to those skilled in the art.

The developer according to the present invention is primarily intended for the production of printing forms for lithographic printing, letterpress printing, gravure printing or screen printing, and also of photoresist images. However, it can also be used in the production of relief copies (for example of texts in Braille), of tanned images or pigmented images.

The layer support in said printing plates preferably consists of metal, in particular of aluminum, steel, zinc, copper or metal alloys, plastic, in particular polyethylene terephthalate (PET), cellulose acetate or polyamide (PA). Supports for screens consist in particular of Perlon gauze. In the case of photoresists, the support is generally a silicone wafer.

The surface of the supports is in many cases pretreated. Thus, aluminum supports are frequently mechanically and/or chemically and/or electrochemically roughened, anodically oxidized and/or hydrophilized. Such pretreatments result in the reproduction layer adhering better thereon, so that lithographic properties of the support - in particular its water acceptance and water retentivity - are improved or so that the support reflects to a lesser extent during the imagewise exposure (antihalation). The same effect can be achieved by applying to the support special layers which comprise, for example, binders, pigments and, if required, additives.

The radiation-sensitive recording materials are prepared by processes which are known per se to the person skilled in the art. In general, the components of the radiation-sensitive layer are dissolved or dispersed in an organic solvent or solvent mixture, the solution or dispersion is applied to the intended support by pouring on, spraying on, emersion, roll application or in a similar manner and the solvents are removed during the subsequent drying.

The imagewise exposure to radiation is effected by means of tubular lamps, pulsed xenon lamps, xenon arc lamps, metal halide-doped high-pressure mercury vapor lamps and carbon arc lamps. In addition, the exposure to light is possible in conventional projection and enlargement units for the light of the metal filament lamps and with contact exposure to customary tungsten filament lamps. Imagewise exposure can also be effected using coherent light of a laser or UV- or IR laser diodes. Lasers of suitable power, for example argon ion lasers, crypton ion lasers, dye lasers, solid-state lasers, helium-cadmium lasers, helium-neon lasers and laser diodes, which emit in particular between 250 and 1100 nm, particularly between 300 and 1000 nm, are suitable. The laser beam can be controlled by a specified program and the exposure can be performed by movements along the lines and along the grid.

The invention also relates to a process for the production of a negative-working reproduction layer being applied to a support, e. g. a lithographic printing plate. Said support preferably is of aluminum or alloys thereof, and is in particular mechanically and/or chemically and/or electrochemically pretreated and/or hydrophilized. Said reproduction layer (e. g. said lithographic printing plate precursor) being exposed imagewise and then being developed with a developer according to the invention.

The invention is illustrated in more detail by the following examples without limiting it thereto. Unless stated otherwise, parts by weight (p.b.w.) and parts by volume (p.b.v.) bear the same relation as that of g to ml. Percentages and ratios are to be understood as weight units.

Further preferred embodiments of the present invention are disclosed in the dependent claims.

### EXAMPLES

### Reference experiment 1

A dip tank lab processor equipped with integrated pre heat and overcoat wash off section was filled with 4100 g of a developer containing the following ingredients:

| | |
|---|---|
| 5.30 p. b. w. | Compound I-1 |
| 6.12 p. b. w. | potassium silicate solution containing 21.0-22.0 weight-% (wt-%) K₂O, 19.5 - 20.5 wt-% SiO₂ and 57.5 - 59.5 wt-% water |
| 0.75 p. b. w. | sodium gluconate |
| 87.83 p. b. w. | deionized water |

The resulting developer had a pH of 13.1 and a conductivity of 23.6 mS/cm. The operating temperature was 25.2 +/- 0.5 °C. Over a period of 2 days the developer was saturated with 60 m² of non imaged N91v^{®} plates. After 10 m² each a plate carrying different common test elements imaged with a Polaris X^{®} equipped with violet laser diode was processed and evaluated. At the same time the developer was characterized by measuring temperature, pH, conductivity and turbidity.

Over the whole process stable values for sensitivity, dot gain and background could be observed. At the end of the test the developer was removed and an almost clean processor was obtained, which was easily to prepare for the next run by rinsing with plain water.

The sedimentation of the exhausted developer was evaluated by taking two samples of about 50 g each and centrifugation at 6000 rpm for 30 minutes. The obtained sediment was decanted over 1 minute, dried in a circulation oven at 100 °C for 45 minutes and equilibrated in an exsiccator over silica gel within 1 hour. Finally 6.68 +/- 0.04 g solid per kg developer was isolated.

### Example 1

The procedure described under reference experiment 1 was repeated, but the processor was filled with a developer containing the following ingredients:

| | |
|---|---|
| 5.00 p. b. w. | Compound II-1 |
| 0.30 p. b. w. | Compound I-1 |
| 6.12 p. b. w. | potassium silicate solution containing 21.0-22.0 wt-% K₂O, 19.5- 20.5 wt-% SiO₂ and 57.5 - 59.5 wt-% water |
| 0.75 p. b. w. | sodium gluconate |
| 87.83 p. b. w. | deionized water |

The sedimentation test as used in reference experiment 1 gave a sludge value of 4.04 +/-0.03 g solid per kg developer.

### Comparative example 1

The procedure described under reference experiment 1 was repeated, but a commercially available photopolymer developer EN 231C^{®} was used under the same conditions. After removal of the exhausted developer the processor looked slightly more contaminated. Rinsing with plain water did not completely remove this contamination. The sedimentation test as used in reference experiment 1 gave a sludge value of 10,9 +/- 0.05 g per kg developer.

### Discussion of reference experiment 1, Example 1 and of Comparative example 1

The results clearly show, that the developer of the present invention is advantageous over the comparative developer, and that according to example 1 the combined use of a polyethyleneoxy/polypropyleneoxy block copolymer and a surfactant of formula (Ia) is more advantageous than using the surfactant of formula (Ia) alone.

### Reference experiments 2-4 and comparative examples 2-8

A stock solution was prepared as follows;

| | | |
|---|---|---|
| 86.4 | p. b. w. | deionized water |
| 6.1 | p. b. w. | potassium silicate solution containing 21.0-22.0 wt-% K₂O, 19.5 - 20.5 wt-% SiO₂ and 57.5 - 59.5 wt-% water |
| 0.75 | p. b. w. | sodium gluconate |

To 93.3 p. b. w. of this solution surfactants and deionized water were added according to table 1.

**Table 1: Type and amounts of additions**

| **No.** | **Surfactant p.b.w.** | **Water p.b.w.** |
|---|---|---|
| Reference experiment 2 | 5.00 Compound I-2 | 1.66 |
| Reference experiment 3 | 5.00 Compound I-3 | 1.66 |
| Reference experiment 4 | 5.00 Compound I-4 | 1.66 |
| Comparative example 2 | 5.00 Arkopal N 150^{®} (Nonylphenol-EO₁₅-H) | 1.66 |
| Comparative example 3 | 5.00 Rewopal MPG 40^{®} (Phenol-EO₄-H) | 1.66 |
| Comparative example 4 | 5.00 Solsperse 27000^{®} (Naphthol-EOₙ-H) | 1.66 |
| Comparative example 5 | 5.00 Lugalvan BNO 24^{®} (Naphthol-EO₂₄-H) | 0 |
| Comparative example 6 | 5.00 Emulsogen LCN 217^{®} (Nonylalcohol-EO₂₁-H) | 1.66 |
| Comparative example 7 | 5.00 Genamin C200^{®} (C₁₂/C₁₄-amine-EO₂₀-H) | 1.66 |
| Comparative example 8 | 5.00 Bermodol SPS 2528^{®} (Fatty acid ethanolamide-EOn-H) | 0.44 |

A 40 x 15 cm sized N91v^{®} plate imaged with different test elements was preheated and the overcoat was washed off. Then the plate is processed manually in 50 ml of the above described developer solutions at 22°C within 30 s giving for all examples a comparable sensitivity. The resulting used developers have been stored at room temperature for 7 days. The sedimentation stability was measured by comparing the turbidity values of the unmoved solutions after 4 hours, 1 day, 3 days and 7 days. The obtained values have been averaged (AV) and the standard deviation was calculated (SD). The turbidity is given in relative turbidity units (TU) versus formazine (F) that is used as a standard. After 7 days each sample was centrifugated at 6000 rpm for 30 minutes. The obtained sediment was decanted over 1 minute, dried in a circulation oven at 100 °C for 45 minutes and equilibrated in an exsiccator over silica gel within 1 hour. The results for the different developers are summarized in table 2, and show the surprising advantage of solution stability (SD) and significant lower tendency for sedimentation, that can only be achieved by using the surfactants of formula (Ia) of the present invention.

**Table 2: Characteristic data, turbidity values and isolated sediment**

| **No.** | **pH** | **Conductivity** | **AV turbidity** | **SD turbidity** | **Sediment** |
|---|---|---|---|---|---|
| | | [mS/cm] | [TU/F] | [TU/F] | [g/kg] |
| Reference experiment 2 | 12.9 | 28.4 | 367 | 5.4 | 0.44 |
| Reference experiment 3 | 12.9 | 27.8 | 354 | 12 | 0.47 |
| Reference experiment 4 | 12.9 | 27.9 | 397 | 24 | 0.52 |
| Comparative example 2 | 12.9 | 28.1 | 409 | 74 | 0.56 |
| Comparative example 3 | 12.9 | 27.4 | 209 | 182 | 0.77 |
| Comparative example 4 | 12.9 | 27.7 | 527 | 274 | 0.73 |
| Comparative example 5 | 12.9 | 27.1 | 548 | 284 | 1.16 |
| Comparative example 6 | 12.9 | 28.3 | 508 | 162 | 0.65 |
| Comparative example 7 | 12.9 | 27.6 | 419 | 45 | 0.65 |
| Comparative example 8 | 12.8 | 25.8 | 394 | 72 | 0.65 |

### Comparative example 9 and examples 2 - 4

The same procedure as described under "Reference experiments 2-4 and comparative examples 2-8" was used, but a stock solution was prepared as follows:

| | | |
|---|---|---|
| 86.93 | p. b. w. | deionized water |
| 5.0 | p. b. w. | Compound II-1 |
| 6.12 | p. b. w. | potassium silicate solution containing 21.0-22.0 wt-% K₂O, 19.5-20.5 wt-% SiO₂ and 57.5-59.5 wt-% water |
| 0.75 | p. b. w. | sodium gluconate |

To 98.8 p. b. w. of this solution different amounts of compound I-1 and water were added according to table 3.

**Table 3: Type and amounts of additions**

| **No.** | **Cosurfactant p.b.w.** | **Water p.b.w.** |
|---|---|---|
| Comparative example 9 | none | 1.20 |
| Example 2 | 0.30 Compound I-1 | 0.90 |
| Example 3 | 0.60 Compound I-1 | 0.60 |
| Example 4 | 0.90 Compound I-1 | 0.30 |

The results for the different developers are summarized in table 4 and again demonstrate the synergistic effect when using a polyethyleneoxy/polypropyleneoxy block copolymer and a surfactant of formula (Ia) in combination.

**Table 4: Characteristic data, turbidity values and isolated sediment**

| **No.** | **pH** | **Conductivity** | **AV turbidity** | **SD turbidity** | **Sediment** |
|---|---|---|---|---|---|
| | | [mS/cm] | [TU/F] | [TU/F] | [g/kg] |
| Comparative example 9 | 12.9 | 27.2 | 351 | 27.6 | 0.46 |
| Example 2 | 12.9 | 27.3 | 371 | 20.8 | 0.45 |
| Example 3 | 12,9 | 27,3 | 370 | 20.1 | 0.42 |
| Example 4 | 12.9 | 27.2 | 345 | 18.0 | 0.40 |

### Example 3 and comparative examples 10-14

The same procedure as described under "Reference experiments 2-4 and comparative examples 2-8" was used, but a stock solution was prepared as follows:

| | | |
|---|---|---|
| 5.0 | p. b. w. | Compound II-1, |
| 3.06 | p. b. w. | potassium silicate solution containing 21.0-22.0 wt-% K₂O, 19.5-20.5 wt-% SiO₂ and 57.5-59.5 wt-% water |
| 0.12 | p. b. w. | Triton B^{®} (Tetra-Na salt of EDTA, 87 %) |
| 91.5 | p. b. w. | deionized water |

To 99.4 p. b. w. of this solution different surfactants and water were added according to table 5.

**Table 5: Type and amounts of additions**

| **No.** | **Cosurfactant p.b.w.** | **Water p.b.w.** |
|---|---|---|
| Example 3 | 0.30 Compound I-1 | 0.30 |
| Comparative example 10 | 0.30 Rewopal MPG 40^{®} (Phenol-EO₄-H) | 0.30 |
| Comparative example 11 | 0.30 Solsperse27000^{®} (Naphthol-EOn-H) | 0.30 |
| Comparative example 12 | 0.30 Genapol C 200^{®} (Coconut fatty alcohol-EO₂₀-H) | 0.30 |
| Comparative example 13 | 0.30 Metolat FC 355^{®} (Ethylenedianmine-EO₁₁-H) | 0.30 |
| Comparative example 14 | 0.30 Emulsogen EPA 073^{®} (Na-Alkylethersulfate-EO₇-H) | 0.30 |

The results for the different developers are summarized in table 6 and demonstrate, that the synergistic effect with surfactants of formula (II) is only present for surfactants of formula (Ia), but not for surfactants of the same class, that have a hydrophobic group not meeting the requirements of the present invention.

**Table 6: pH, turbidity values and isolated sediment**

| **No.** | **pH** | **AV turbidity** [TU/F] | **SD turbidity** [TU/F] | **Sediment** [g/kg] |
|---|---|---|---|---|
| Example 3 | 12.8 | 438 | 21.0 | 0.46 |
| Comparative example 10 | 12.6 | 501 | 107.3 | 0.67 |
| Comparative example 11 | 12,6 | 529 | 110.2 | 0.61 |
| Comparative example 12 | 12.6 | 447 | 24.6 | 0.60 |
| Comparative example 13 | 12,6 | 547 | 202.1 | 0.64 |
| Comparative example 14 | 12,6 | 485 | 42.2 | 0.63 |

## Claims

1. An alkaline developer for irradiated radiation sensitive compositions, which developer is based on water and comprises at least one alkaline reacting silicate, **characterized in that** the developer has a pH of at least 11 and comprises a surfactant of formula (Ia) 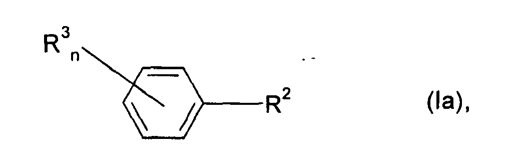 wherein
R³ represents a 1,1-phenylethyl or a t-butyl group,
n means 2 or 3, and
R² represents a hydrophilic group comprising a polyethyleneoxy group with at least 6 ethyleneoxy units,
and at least one additional surfactant of formula (IIa) 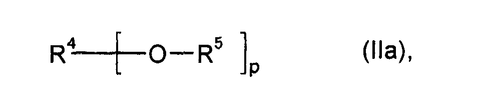 wherein
R⁴ represents H, a substituted or unsubstituted alkyl group having at least 1 carbon atom, or a monosubstituted or unsubstituted aryl group having at least 6 carbon atoms,
R⁵ mutually independently represents a polyoxyalkylene group, and
p represents an integer of at least 1.
and wherein the concentration of the silicate is at least 0.2 weight-% and that of the surfactant of formula (Ia) at least 0.05 weight-%, in each case based on the total weight of the developer.

2. An alkaline developer according to claim 1, wherein the developer solution has a pH in the range from 11.5 to 14.

3. An alkaline developer according to claims 1 or 2, wherein the surfactant of formula (Ia) is of formula (Ib): 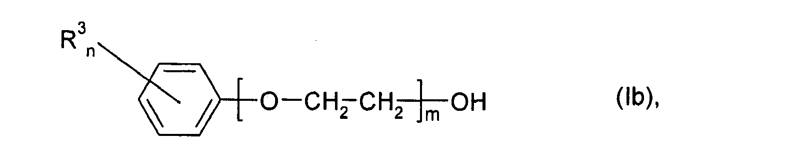 wherein
R³ and n have the same meaning as given in the preceding claims, and
m is an integer of at least 6.

4. An alkaline developer according to claim 3, wherein m is an integer from 8 to 50.

5. An alkaline developer according to any of the preceding claims, wherein the additional surfactant is of formula (IIb), (IIc) or (IId):
HO-R⁶ (IIb), 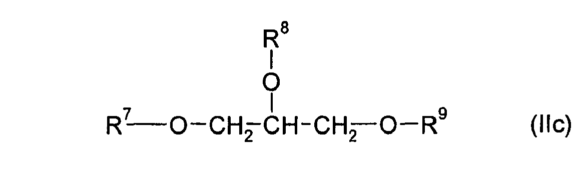
or 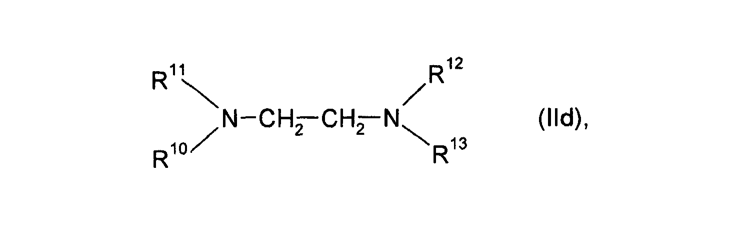 wherein R⁶ to R¹³ mutually independently consist of polyoxyethylene and polyoxypropylene groups.

6. An alkaline developer according to claim 5, wherein R⁶ to R¹³ mutually independently represent -Z¹-Z²-H, -Z²-Z¹-H, -Z¹-Z²-Z¹-H and/or -Z²-Z¹-Z²-H, wherein
Z¹ represents -O-(-CH₂-CH₂-O-)ₓ-,
Z² represents -O-(-CH₂-CH(CH3)-O-)_{y}-, and wherein
x, y mutually independently are integers from 3 to 200.

7. An alkaline developer according to claim 6, wherein the Z² block(s) of the additional surfactant have in total a molecular weight of at least 2000 g/mol, and the surfactant of formula (IIb), (IIc) or (IId) comprises 25 to 55 weight-% Z¹ blocks based on the total molecular weight of the Z¹ blocks and the Z² blocks in the molecule.

8. An alkaline developer according to any of the preceding claims, wherein the ratio by weight of the surfactant of formula (Ia) to the additional surfactant is from 1 : 1 to 1 : 80.

9. A method of making a lithographic printing plate comprising the steps of imagewise exposing a lithographic printing plate precursor and processing it in an alkaline developer according to any of the preceding claims.

## Patentansprüche

1. Ein alkalischer Entwickler für belichtete strahlungsempfindliche Zusammensetzungen, wobei der Entwickler ein wässriger Entwickler ist und mindestens ein reaktives alkalisches Silikat enthält, **dadurch gekennzeichnet, dass** der pH-Wert des Entwicklers mindestens 11 beträgt und ein Tensid der Formel (Ia) : 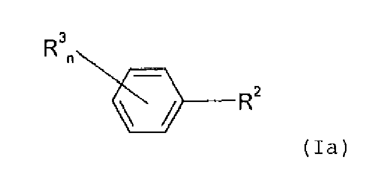 in der :
R³ eine 1,1-Phenylethylgruppe oder t-Butylgruppe bedeutet,
n 2 oder 3 bedeutet und
R² eine hydrophile Gruppe, die eine Polyethylenoxygruppe mit mindestens 6 Ethylenoxyeinheiten umfasst, bedeutet,
und mindestens ein zusätzliches Tensid der Formel (IIa) enthält : 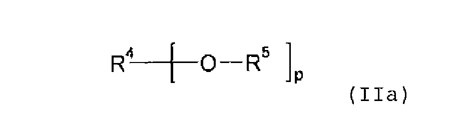 in der :
R⁴ ein Wasserstoffatom, eine gegebenenfalls substituierte Alkylgruppe mit mindestens einem Kohlenstoffatom oder eine monosubstituierte oder nicht-substituierte Arylgruppe mit mindestens 6 Kohlenstoffatomen bedeutet,
R⁵ unabhängig voneinander eine Polyoxyalkylengruppe bedeutet und
p eine ganze Zahl von mindestens 1 bedeutet,
und **dadurch gekennzeichnet, dass** das Silikatverhältnis mindestens 0,2 Gew.-% und das Verhältnis des Tensids der Formel (Ia) mindestens 0,05 Gew.-% beträgt, jeweils bezogen auf das Gesamtgewicht des Entwicklers.

2. Alkalischer Entwickler nach Anspruch 1, **dadurch gekennzeichnet, dass** die Entwicklerlösung einen pH zwischen 11,5 und 14 aufweist.

3. Alkalischer Entwickler nach Anspruch 1 oder 2, **dadurch gekennzeichnet, dass** das Tensid der Formel (Ia) ein Tensid der folgenden Formel (Ib) ist : 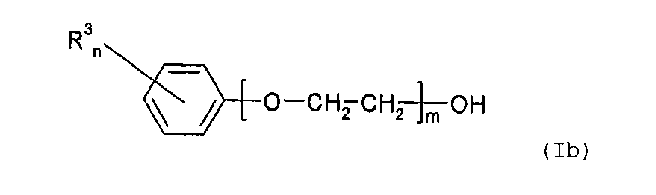 in der :
R³ und n dieselbe Bedeutung wie in den vorigen Ansprüchen haben und
m eine ganze Zahl von mindestens 6 bedeutet.

4. Alkalischer Entwickler nach Anspruch 3, **dadurch gekennzeichnet, dass** m eine ganze Zahl zwischen 8 und 50 ist.

5. Alkalischer Entwickler nach einem der vorstehenden Ansprüche, **dadurch gekennzeichnet, dass** das zusätzliche Tensid der Formel (IIb), (IIc) oder (IId) entspricht :
HO-R⁶ (IIb) 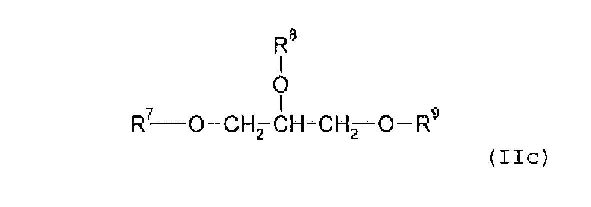
oder 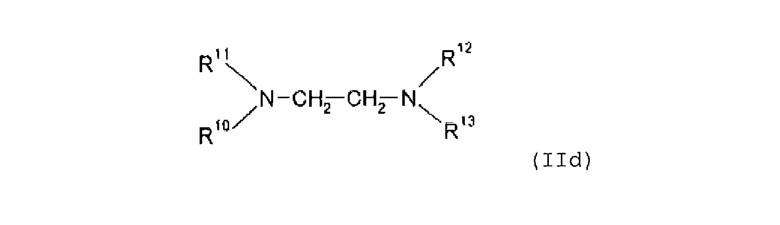 in denen R⁶ bis R¹³, unabhängig voneinander, eine Polyoxyethylengruppe und eine Polyoxypropylengruppe bedeuten.

6. Alkalischer Entwickler nach Anspruch 5, **dadurch gekennzeichnet, dass** R⁶ bis R¹³, unabhängig voneinander, -Z¹-Z²-H, -Z²-Z¹-H, -Z¹-Z²-Z¹-H und/oder -Z²-Z¹-Z²-H bedeuten,
in denen :
Z¹ -O-(-CH₂-CH₂-O-)ₓ- bedeutet,
Z² -O-(-CH₂-CH(CH₃)-O-)_{y}- bedeutet und
x und y, unabhängig voneinander, eine ganze Zahl zwischen 3 und 200 bedeuten.

7. Alkalischer Entwickler nach Anspruch 6, **dadurch gekennzeichnet, dass** der Z²-Block bzw. die Z²-Blöcke des zusätzlichen Tensids ein Gesamtmolekulargewicht von mindestens 2.000 g/Mol aufweist bzw. aufweisen und das Tensid der Formel (IIb), (IIc) oder (IId) zwischen 25 Gew.-% und 55 Gew.-% an Z¹-Blöcken, bezogen auf das Gesamtmolekulargewicht der Z¹-Blöcke und der Z²-Blöcke im Molekül, enthält.

8. Alkalischer Entwickler nach einem der vorstehenden Ansprüche,
**dadurch gekennzeichnet, dass** das Gewichtsverhältnis des Tensids der Formel (Ia) zum zusätzlichen Tensid zwischen 1:1 und 1:80 liegt.

9. Ein Verfahren zur Herstellung einer lithografischen Druckplatte, das die Schritte der bildmäßigen Belichtung einer Vorstufe einer lithografischen Druckplatte und der Entwicklung dieser Vorstufe in einem alkalischen Entwickler nach einem der vorstehenden Ansprüche umfasst.

## Revendications

1. Un révélateur alcalin pour compositions sensibles au rayonnement irradiées, ledit révélateur étant un révélateur aqueux et contenant au moins un silicate alcalin réactif, **caractérisé en ce que** le révélateur présente une valeur de pH minimale de 11 et contient un agent tensioactif répondant à la formule (Ia) : 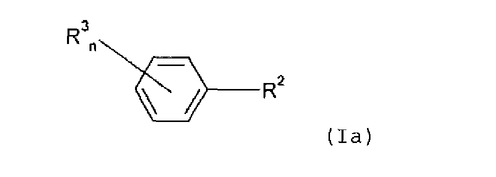 où :
R³ représente un groupe 1,1-phényléthyle ou un groupe t-butyle,
n représente 2 ou 3 et
R² représente un groupe hydrophile comprenant un groupe polyéthylèneoxy contenant au moins 6 unités éthylèneoxy,
et au moins un agent tensioactif supplémentaire répondant à la formule (IIa) : 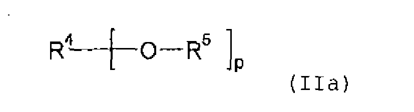 où :
R⁴ représente un atome d'hydrogène, un groupe alkyle éventuellement substitué comprenant au moins un atome de carbone ou un groupe aryle monosubstitué ou non substitué comprenant au moins 6 atomes de carbone,
R⁵ représente, indépendamment l'un de l'autre, un groupe polyoxyalkylène, et
p représente un nombre entier d'au moins 1,
et **caractérisé en ce que** la concentration du silicate s'élève à au moins 0,2% en poids et que celle de l'agent tensioactif répondant à la formule (Ia) s'élève à au moins 0,05% en poids, les deux pourcentages en poids étant exprimés par rapport au poids total du révélateur.

2. Révélateur alcalin selon la revendication 1, **caractérisé en ce que** la solution révélatrice présente une valeur de pH comprise entre 11,5 et 14.

3. Révélateur alcalin selon la revendication 1 ou 2, **caractérisé en ce que** l'agent tensioactif répondant à la formule (Ia) répond à la formule (Ib) : 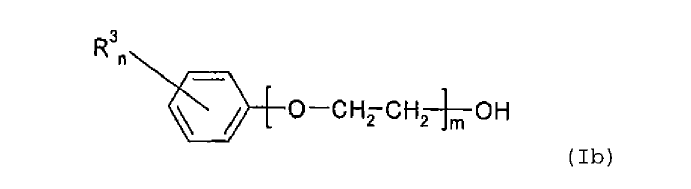 où :
R³ et n ont la même signification que dans les revendications précédentes, et
m représente un nombre entier d'au moins 6.

4. Révélateur alcalin selon la revendication 3, **caractérisé en ce que** m est un nombre entier compris entre 8 et 50.

5. Révélateur alcalin selon l'une quelconque des revendications précédentes, **caractérisé en ce que** l'agent tensioactif supplémentaire répond à la formule (IIb), (IIc) ou (IId) :
HO-R⁶ (IIb) 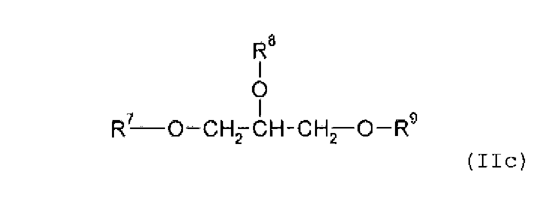
ou 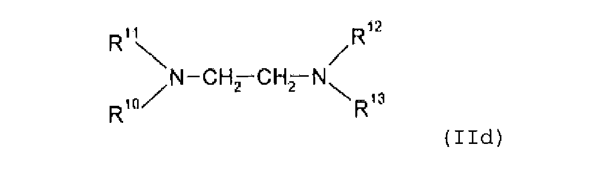 où R⁶ à R¹³ représentent, indépendamment l'un de l'autre, un groupe polyoxyéthylène et un groupe polyoxypropylène.

6. Révélateur alcalin selon la revendication 5, **caractérisé en ce que** R⁶ à R¹³ représentent, indépendamment l'un de l'autre, -Z¹-Z²-H, -Z²-Z¹-H, -Z¹-Z²-Z¹-H et/ou -Z²-Z¹-Z²-H,
où :
Z¹ représente -O-(-CH₂-CH₂-O-)ₓ-,
Z² représente -O-(-CH₂-CH(CH₃)-O-)_{y}- et
x et y représentent, indépendamment l'un de l'autre, un nombre entier compris entre 3 et 200.

7. Révélateur alcalin selon la revendication 6, **caractérisé en ce que** le(s) bloc(s) Z² de l'agent tensioactif supplémentaire présente(nt) un poids moléculaire total d'au moins 2.000 g/mole et que l'agent tensioactif répondant à la formule (IIb), (IIc) ou (IId) comprend entre 25% en poids et 55% en poids de blocs Z¹ par rapport au poids moléculaire total des blocs Z¹ et des blocs Z² compris dans la molécule.

8. Révélateur alcalin selon l'une quelconque des revendications précédentes, **caractérisé en ce que** le rapport pondéral de l'agent tensioactif répondant à la formule (Ia) à l'agent tensioactif supplémentaire est compris entre 1:1 et 1:80.

9. Une méthode pour la fabrication d'une plaque d'impression lithographique, comprenant les étapes de l'exposition sous forme d'image d'un précurseur de plaque d'impression lithographique et de son développement dans un révélateur alcalin selon l'une quelconque des revendications précédentes.
